# EUROPÄISCHE PATENTSCHRIFT

(11) **EP 0 222 272 B1**
(45) Veröffentlichungstag und Bekanntmachung des Hinweises auf die Patenterteilung: **29.12.1993**
(21) Anmeldenummer: 86115110.8
(22) Anmeldetag: 31.10.1986
(51) Int. Cl.: H03H 9/10

(54) **Flachgehäuse zur hermetischen Kapselung von piezoelektrischen Bauelementen**
Flat housing for hermetically enclosing piezo-electric components
Boîtier plat pour encastrement hermétique d'éléments de montage piézo-électriques

(30) Priorität: 07.11.1985 DE 3539504
(43) Veröffentlichungstag der Anmeldung: 20.05.1987
(73) Patentinhaber: Schott Glaswerke, 55122 Mainz (DE); Carl-Zeiss-Stiftung trading as SCHOTT GLASWERKE, 55122 Mainz (DE)
(72) Erfinder: Fuchs, Dieter, D-8300 Landshut (DE)
(74) Vertreter: Fuchs Mehler Weiss

(56) Entgegenhaltungen:
- DE-A- 3 026 655
- US-A- 4 293 986
- US-A- 4 354 133
- PATENT ABSTRACTS OF JAPAN, Band 7, Nr. 140 (E-182)[1285], 18. Juni 1983; & JP-A-58 54 716 (FUJITSU K.K.) 31-03-1983
- PATENT ABSTRACTS OF JAPAN, Band 4, Nr. 109 (E-20)[591], 6. August 1980; & JP-A-55 67 214 (DAINI SEIKOSHA K.K.) 21-05-1980

## Beschreibung

Die vorliegende Erfindung betrifft ein Gehäuse zur hermetischen Kapselung von piezoelektrischen Bauelementen, insbesondere von Schwingquarzen.

Schwingquarze werden bisher in einer Weise gekapselt, daß die Quarzscheibe, die auf jeder Seite eine Elektrode aufweist, in vertikaler Stellung zwischen zwei Metallfedern klemmend gehaltert wird, die durch eine Bodenplatte, von dieser isoliert, hindurchreichen, und daß über der Bodenplatte ein Gehäuse angeordnet wird, dessen Unterkanten mit der Bodenplatte hermetisch dicht verbunden werden.

Die Suche nach piezoelektrischen Bauelementen mit geringerem Platzbedarf und niedrigeren Herstellungskosten hat zu flachen Gehäusen geführt, in denen die Schwingquarzscheibe horizontal angeordnet ist, wobei die beiden Leiter in Richtung zur Leiterplatte umgebogen und auf dieser befestigt sind (SMD = surface mounting device).

Ein solcher flacher piezoelektrischer Resonator ist z.B. in der DE-OS 34 27 646 beschrieben. Das dort beschriebene Bauelement hat jedoch noch Nachteile. Beispielsweise ist eine simultane Aufdampfung beider Elektroden auf die Schwingquarzscheibe nicht möglich, was den Herstellungsprozeß verlängert und erschwert. Auch kann dort der Abgleich der Resonanzfrequenz ebenfalls nicht simultan erfolgen, und ein Feinabgleich der Resonanzfrequenz nach dem Gehäuseverschluß ist nicht möglich.

Die gleichen Nachteile weist auch der in der JP-A-5854716 vorgestellte piezoelektrische Oszillator auf, dessen Bauelemente aus Keramik bestehen, wobei aber das Flachgehäuse schon als Dual-In-Line Gehäuse ausgebildet und somit mit dem Rastermuster gedruckter Schaltungen bzw. Leiterplatten kompartibel ist.

In der JP-A-5567214 wird ein Flachgehäuse aus Glas für einen Kristalloszillator vorgestellt, welches einen Schichtenaufbau aufweist und worin der Schwingquarz in der Mitte zweier ringförmiger Glasschichten angeordnet ist, die nach oben und unten durch ein Deck- bzw. Bodenglas abgedeckt sind, wobei die einzelnen Glasschichten mittels Glaslot miteinander versiegelt sind. Auch hier ist ein simultanes Aufdampfen der Elektroden auf den Schwingquarz nicht möglich, dieser ist vielmehr im vorgefertigten Zustand zum Einbau vorgesehen.

Ziel der vorliegenden Erfindung ist ein Flachgehäuse zur hermetischen Kapselung von piezoelektrischen Bauelementen, das sich für eine besonders rationelle und automatisierte Oberflächenmontage (SMD-Technologie) eignet, und das folgende Forderungen erfüllt:
1. Der Gehäuseverschluß muß dicht gegenüber permanenten Gasen sein und darf keine Permeation von Gasen und Dämpfen (insbesondere Wasserdampf) zulassen.
2. Das Flachgehäuse soll eine möglichst geringe Bauhöhe besitzen und eine hohe Packungsdichte auf der Leiterplatte ermöglichen.
3. Die Montage der Quarzscheibe und der Gehäuseverschluß sollen automatisierbar sein.
4. Eine simultane Aufdampfung der Elektroden auf die Schwingquarzscheibe, d.h. von beiden Seiten gleichzeitig, ohne Schattenbildung ist erstrebenswert.
5. Der Abgleich der Resonanzfrequenz sollte ebenfalls simultan erfolgen können.
6. Der Möglichkeit eines Feinabgleiches der Resonanzfrequenz nach dem Gehäuseverschluß sollte ebenfalls gegeben sein.
7. Die Temperaturbelastung des piezoelektrischen Elementes (Quarz) während der Montage und bei dem Gehäuseverschluß soll möglichst niedrig sein.

Dieses Ziel wird mit einem Flachgehäuse gemäß den Patentansprüchen erreicht.

Um die gestellten Forderungen, vor allem bezüglich der Dichtheit des Flachgehäuses, zu erfüllen, müssen sämtliche Gehäuseeinzelteile dilathermisch aufeinander abgestimmt sein, d.h. die Wärmedehnungskoeffizienten der verschiedenen Einzelteile müssen in dem bei der Versiegelung durchlaufenden Temperaturintervall übereinstimmen.

Erfindungsgemäß wird als Grundwerkstoff Glas verwendet. Beispielsweise sind zwei Ausführungsformen möglich:
1) Die verwendeten Gläser haben eine Wärmedehnung von ca. 9x10⁻⁶/K, oder
2) die verwendeten Gläser haben eine Wärmedehnung von ca. 5x10⁻⁶/K.

Die der Ausführungsform 1) bestehen die lamellenförmigen Anschlußleiter zweckmäßigerweise aus einer NiFe-Legierung; bei der Ausführungsform 2) bestehen sie zweckmäßigerweise aus einer NiFeCo-Legierung.

Als Dichtungsmaterial können verschiedene Werkstoffe verwendet werden. Beachtet man aber die Forderung, daß kein Wasserdampf permeieren darf, bieten sich stabile oder keramisierende Glaslote an. Diese Glaslote müssen selbstverständlich ebenfalls dilathermisch an die zu verbindenden Einzelteile angepaßt sein.

Bei Berücksichtigung der bei er Verlötung der Montageeinheit mit eingebautem Quarzelement mit der Boden- und Abdeckplatte verbundenen thermischen Belastung des Quarzes wird die Ausführungsform 1) bevorzugt.

### Aufbau der Montageeinheit:

Die beiden Trägerrahmen sind aus Sinterglas hergestellt und werden stirnseitig mit Glaslot beschichtet. Zwischen diese beiden Trägerrahmen werden die Anschlußlamellen eingelegt. Diese Einheit wird, erforderlichenfalls unter Anwendung von leichtem Druck, verlötet.

Diese Lamellen können sowohl als separate Anschluß- und Montageelemente als auch als durchgehende, parallel zueinander laufende Streifenlamellen eingebettet werden. Die Schwingquarzscheibe kann an diesen Einzellamellen bzw. an den Streifenlamellen im Innenraum der Montageeinheit mittels eines Leitklebers befestigt werden. Erforderlichenfalls werden an die Lamellen geeignete Feder- und Halterungssysteme zur Aufnahme der Quarzscheibe angeschweißt. Außerdem können die Lamellen innerhalb der Montageeinheit prägetechnisch zu geeigneten Halterungs- bzw. Federsystemen geformt werden. Abhängig von der Halterungs- bzw. Federform wird die Quarzscheibe bei gleichstarken Trägerrahmen nicht in der Mitte der Montageeinheit zu liegen kommen. Dies kann aber dadurch ausgeglichen werden, daß, abhängig von der Federform, die Trägerrahmen unterschiedliche Stärken derart besitzen, daß die Quarzscheibe in der Mitte des Gehäuses zu liegen kommt.

Für den Einbau der Quarzscheibe bieten sich zwei Verfahren an:
1. Eine bereits mit aufgedampften Elektroden versehene Quarzscheibe wird mit einem Leitkleber an den Trägerelementen (Lamellen) befestigt. Da die Montageeinheit von beiden Seiten in gleichem Maße zugänglich ist, kann dann ein simultaner Frequenzabgleich erfolgen.
2. Eine Quarzscheibe wird mit einem Kleber an den Trägerelementen befestigt. Sodann erfolgt das Aufdampfen der Elektroden simultan. Es besteht dabei die Möglichkeit, sofort die erwünschte Resonanzfrequenz, ohne nachträglichen Abgleich der Resonanzfrequenz, zu erreichen. Hierbei muß allerdings darauf geachtet werden, daß nicht durch ungünstige Federgestaltung eine Schattenbildung bei der Bedampfung erfolgt.

### Verschluß des Flachgehäuses:

Die Montageeinheit mit dem darin eingebauten abgestimmten Quarz wird mit der Boden- und Abdeckplatte mittels des auf der Stirnfläche der Montageeinheit befindlichen Glaslotes, erforderlichenfalls unter Anwendung eines leichten Druckes, verlötet. Boden- und Abdeckplatte können sowohl als Sinter-als auch Klarglasteile ausgebildet sein. Da während des Lötprozesses geringe Abdampfraten auftreten und damit zu einer "Massenbelegung" des Quarzes und der damit verbundenen Drift der Resonanzfrequenz führen können, ist eventuell eine Nachtrimmung erforderlich, die mittels eines Laserstrahles dann möglich ist, wenn Boden- und Abdeckplatte aus Klarglas-Planplatten bestehen.

### Formung der Anschlußlamellen für die Oberflächenmontage:

Nach der Komplettierung des Gehäuses ist es erforderlich, die Anschlußlamellen für die Oberflächenmontage entweder in der Form L oder Y zu verformen. Es besteht aber auch die Möglichkeit, bereits vorgeformte Lamellen in die Montageeinheit einzubetten. Die letzterwähnte Lösung bietet den Vorteil, daß die Einglasung nicht mehr belastet wird. Bei der nachträglichen Formgebung der Lamellen würde aber in jedem Fall eine mechanische Balastung der Einglasung erfolgen, die im extremen Fall zu Undichtigkeiten des Gehäuses führen könnte.

Im Sinne einer rationellen, automatisierten Fertigung ist es möglich, die Lamellen aus einem Streifenband (Strip) zu fertigen. Dieses Verfahren kann auch für die vorgeformten Lamellen angewandt werden.

Die Erfindung wird durch die Zeichnung näher erläutert.

Figur 1 zeigt das erfindungsgemäße Flachgehäuse in perspektivischer Darstellung, teilweise geschnitten.

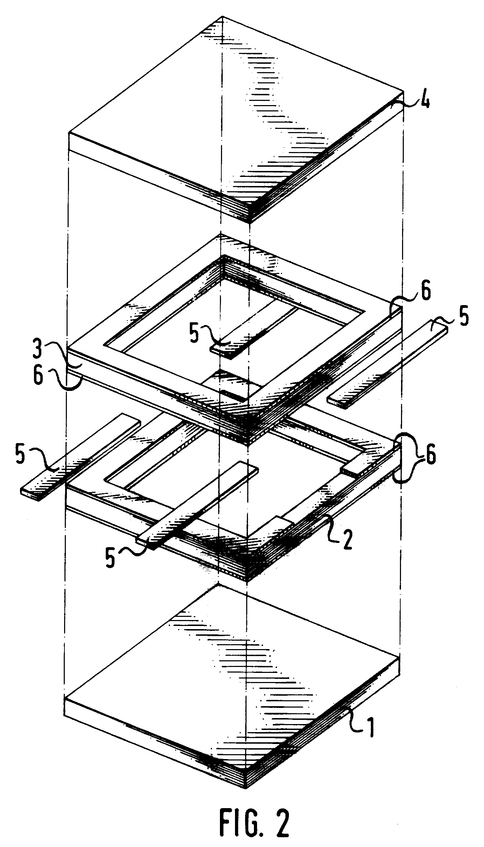

Figur 2 und Figur 3 sind Explosionsdarstellungen und zeigen die Einzelteile des Gehäuses, bzw. der Montageeinheit.

Das Gehäuse besteht insgesamt aus folgenden Teilen:
Bodenplatte 1;
Abdeckplatte 4;
Die beiden Trägerrahmen 2 und 3 sind auf den Stirnseiten mit einem Dichtungsmaterial 6 beschichtet.

Die elektrischen Anschlußelemente 5 sind als dünne metallische Lamellen ausgebildet. Sie dienen später sowohl als Träger für die Quarzscheibe, dem elektrischen Anschluß der Elektroden als auch der Montage auf der Leiterplatte und dem elektrischen Anschluß an die Schaltung.

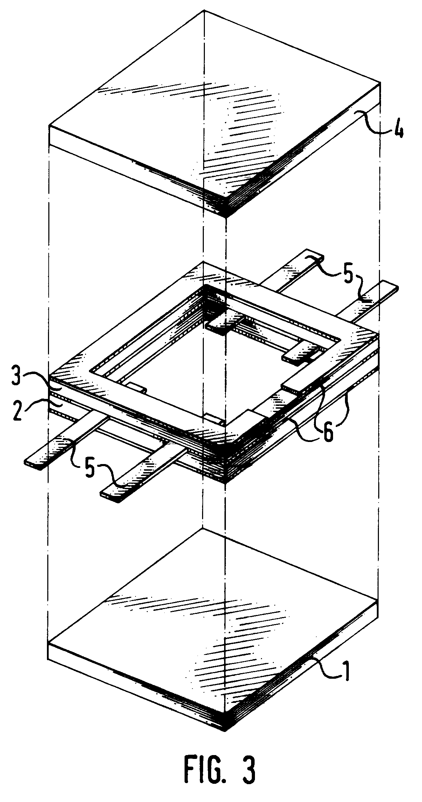

Bei der Vormontage werden die beiden mit Dichtungsmaterial beschichteten Trägerahmen 2, 3 gleichzeitig mit den dazwischenliegenden Anschlußlamellen 5 hermetisch verbunden. Diese Einheit stellt dann die eigentliche Montageeinheit für den Schwingquarz dar, bestehend aus den Einzelelementen 2, 3, 5 und 6 (Figur 3).

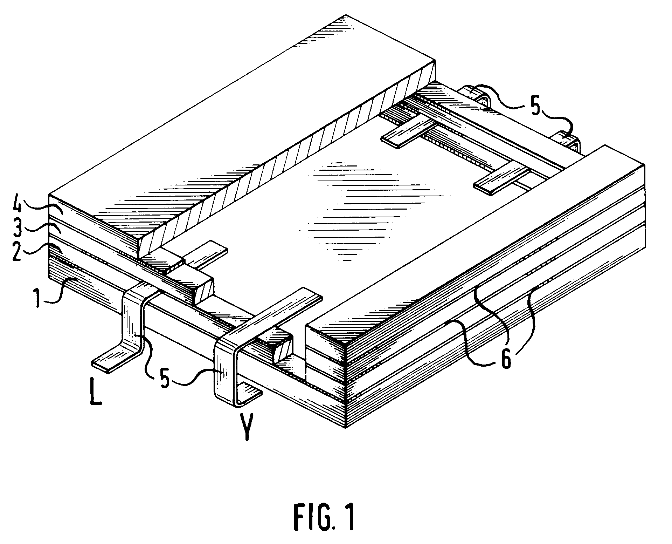

Nach der Montage des Schwingquarzes und nach dem Abgleich der Resonanzfrequenz wird die mit dem abgestimmten Quarz versehene Montageeinheit in einem Arbeitsgang mittels des auf der äußersten oberen und unteren Stirnfläche der Montageeinheit vorhandenen Dichtungsmaterials mit der Boden- und Abdeckplatte hermetisch versiegelt (Fig. 1).

## Patentansprüche

1. Flachgehäuse zur hermetischen Kapselung von piezoelektrischen Bauelementen, zur Verwendung bei der Oberflächenmontage (SMD), bestehend aus einer Bodenplatte (1), einer Abdeckplatte (4) und zwischen diesen angeordneten, in das Gehäuse hineinführenden, in einer Montageeinheit integrierten lamellenförmigen Anschlußleitern (5), wobei Abdeckplatte (4) und Bodenplatte (1) aus Glas bestehen,
dadurch gekennzeichnet, daß
(a) die Montageeinheit aus zwei Trägerrahmen (2, 3) aus Sinterglas besteht, die zusammen mit den lamellenförmigen Anschlußleitern (5) mittels eines keramisierenden Glaslots (6) hermetisch miteinander verbunden sind und so eine beidseitig im gleichen Maße zugängliche Einheit bilden,
(b) Abdeckplatte (4), Bodenplatte (1) und die dazwischen liegende Montageeinheit mittels eines stabilen oder keramisierenden Glaslots (6) hermetisch miteinander verbunden sind, wobei
(c) sämtliche das Flachgehäuse aufbauenden Teile, einschließlich der lamellenförmigen metallischen Anschlußleiter und der Glaslote (1, 2, 3, 4, 5, 6) für das bei der hermetischen Verbindung zu durchlaufende Temperaturintervall dilathermisch aufeinander abgestimmt sind.

2. Flachgehäuse nach Anspruch 1, dadurch gekennzeichnet, daß die verwendeten Gläser eine Wärmedehnung von ca. 9 x 10⁻⁶/K aufweisen.

3. Flachgehäuse nach den Ansprüchen 1 und 2, dadurch gekennzeichnet, daß die lamellenförmigen Anschlußleiter aus einer Ni-Fe-Legierung bestehen.

4. Flachgehäuse nach Anspruch 1, dadurch gekennzeichnet, daß die verwendeten Gläser eine Wärmedehnung von ca. 5 x 10⁻⁶/K aufweisen.

5. Flachgehäuse nach den Ansprüchen 1 und 4, dadurch gekennzeichnet, daß die lamellenförmigen Anschlußleiter aus einer Ni-Fe-Co-Legierung bestehen.

6. Flachgehäuse nach jedem der Ansprüche 1 bis 5, dadurch gekennzeichnet, daß die Boden- und die Abdeckplatte aus Klarglas bestehen.

7. Flachgehäuse nach jedem der Ansprüche 1 bis 6, dadurch gekennzeichnet, daß die lamellenförmigen Anschlußleiter Bauteile sind, die für die Oberflächenmontage (SMD) bereits L- oder Y-förmig vorgeformt worden sind.

## Claims

1. A flat housing for hermetically enclosing piezo-electric components, for use in surface mounting (SMD), comprising a base plate (1), a cover plate (4) and laminated connection terminals (5) which are disposed therebetween and are integrated in a mounting unit and lead into the housing, the cover plate (4) and the base plate (1) being made from glass,
characterised in that
(a) the mounting unit comprises two support frames (2, 3) of sintered glass which, together with the laminated connection terminals (5), are hermetically interconnected by means of a ceramizing glass solder (6) and thus form a unit which is accessible to the same extent on both sides,
(b) cover plate (4), base plate (1) and the mounting unit located therebetween are hermetically interconnected by means of a stable or ceramizing glass solder (6), wherein
(c) all the parts forming the flat housing, including the laminated metal connection terminals and the glass solders (1, 2, 3, 4, 5, 6) are matched to one another in their heat expansion for the temperature interval to be passed through during the hermetic connection.

2. A flat housing as claimed in claim 1, characterised in that the glasses used have a thermal expansion of approximately 9 x 10⁻⁶/K.

3. A flat housing as claimed in claims 1 and 2, characterised in that the laminated connection terminals are made from an Ni-Fe alloy.

4. A flat housing as claimed in claim 1, characterised in that the glasses used have a thermal expansion of approximately 5 x 10⁻⁶/K.

5. A flat housing as claimed in claims 1 and 4, characterised in that the laminated connection terminals are made from an Ni-Fe-Co alloy.

6. A flat housing as claimed in any of claims 1 to 5, characterised in that the base plate and the cover plate are made from clear glass.

7. A flat housing as claimed in any of claims 1 to 6, characterised in that the laminated connection terminals are components which have already been preformed to an L-shape or a Y-shape for the surface mounting (SMD).

## Revendications

1. Boîtier plat pour enfermement hermétique de composants piézo-électriques à utiliser pour le montage en surface (SMD), constitué d'une plaque de fond (1), d'une plaque de recouvrement (4) et de conducteurs de connexion lamelliformes (5) disposés entre elles, pénétrant dans le boîtier et intégrés à une unité de montage, la plaque de recouvrement (4) et la plaque de fond (1) étant en verre, caractérisé en ce que :
(a) l'unité de montage est constituée de deux cadres de support (2, 3) en verre fritté, qui sont unis l'un à l'autre de manière hermétique, conjointement avec les conducteurs de connexion lamelliformes (5), à l'aide d'une brasure vitreuse à effet céramisant (6) et forment de la sorte une unité accessible des deux côtés dans la même mesure;
(b) la plaque de recouvrement (4), la plaque de fond (1) et l'unité de montage qui se trouve entre elles sont unies hermétiquement l'une à l'autre via une brasure vitreuse stable ou à effet céramisant (6), et
(c) toutes les pièces constituant le boîtier plat, y compris les conducteurs de connexion métalliques lamelliformes et les brasures vitreuses (1, 2, 3, 4, 5, 6), sont adaptées l'une à l'autre en matière de dilatation thermique en vue de l'intervalle de température auquel elles sont soumises lors de l'assemblage hermétique.

2. Boîtier plat selon la revendication 1, caractérisé en ce que les verres utilisés ont une dilatation thermique d'environ 9 x 10⁻⁶/K.

3. Boîtier plat selon les revendications 1 et 2, caractérisé en ce que les conducteurs de connexion lamelliformes sont faits d'un alliage Ni-Fe.

4. Boîtier plat selon la revendication 1, caractérisé en ce que les verres utilisés ont une dilatation thermique d'environ 5 x 10⁻⁶/K.

5. Boîtier plat selon les revendications 1 et 4, caractérisé en ce que les conducteurs de connexion lamelliformes sont faits d'un alliage Ni-Fe-Co.

6. Boîtier plat selon l'une quelconque des revendications 1 à 5, caractérisé en ce que la plaque de fond et la plaque de recouvrement sont en verre transparent.

7. Boîtier plat selon l'une quelconque des revendications 1 à 6, caractérisé en ce que les conducteurs de connexion lamelliformes sont des éléments qui sont déjà préfaçonnés en L ou en Y en vue du montage en surface (SMD).
